# EUROPÄISCHE PATENTSCHRIFT

(11) **EP 1 959 528 B1**
(45) Veröffentlichungstag und Bekanntmachung des Hinweises auf die Patenterteilung: **12.04.2017**
(21) Anmeldenummer: 08002400.3
(22) Anmeldetag: 08.02.2008
(51) Int. Cl.: H01S 5/024, H01S 5/40, H01L 23/473, H01S 5/022

(54) **Diodenlaseranordnung sowie Verfahren zum Herstellen einer solchen Anordnung**
Diode laser assembly and method for producing such an assembly
Système de laser à diodes ainsi que procédé de fabrication d'un tel système

(30) Priorität: 13.02.2007 DE 102007007661; 15.02.2007 DE 102007008027
(43) Veröffentlichungstag der Anmeldung: 20.08.2008
(73) Patentinhaber: Laserline Gesellschaft für Entwicklung und Vertrieb von Diodenlasern mbH, 56218 Mülheim-Kärlich (DE); Rogers Germany GmbH, 92676 Eschenbach (DE)
(72) Erfinder: Schulz-Harder, Dr. Jürgen, D-91207 Lauf (DE); Meyer, Dipl.-Ing. Andreas, D-93173 Wenzenbach (DE); Krause Volker, D-56295 Lonnig (DE); Ullmann, Christoph, D-53604 Bad Honnef (DE)
(74) Vertreter: Glück Kritzenberger Patentanwälte PartGmbB

(56) Entgegenhaltungen:
- EP-A1- 1 696 526
- DE-A1- 19 506 093
- JP-A- 2004 146 720
- US-A- 5 848 083
- US-B1- 6 647 035

## Beschreibung

Die Erfindung bezieht sich auf eine Diodenlaseranordnung gemäß Oberbegriff Patentanspruch 1 sowie auf ein Verfahren zum Herstellen einer Diodenlaseranordnung gemäß Oberbegriff Patentanspruch 18.

Hochleistungsdiodenlaser basieren heute überwiegend auf Breitstreifenlasern mit Chipabmessungen von 0,5 ... 1 mm x 1...4 mm und einer Chiphöhe von 100 ... 150 µm. Die laseraktive Schicht der Chips, in der die Laserstrahlung erzeugt wird, ist dabei entlang der größeren Kantenlänge der Chips ausgerichtet, wobei die gebrochenen Kanten eine sehr gute Ebenheit aufweisen und dadurch die End- und Auskoppelspiegel des Lasers bilden. Die Laserstrahlung tritt aus dem Auskoppelspiegel auf einer Breite von typischerweise nur 50 ... 200µm aus dem Chipmaterial aus. Bei einer Emitterbreite von 100 µm lässt sich eine Ausgangsleistung bis zu 15 W erreichen.

Für Hochleistungsdiodenlaser werden derartige Breitstreifenlaser oder Emitter zu Laserbarren zusammengefasst, in denen dann bis zu hundert einzelne Emitter auf einer Länge von bis zu 10 mm aufeinander folgend vorgesehen sind. Die Endspiegel und Auskoppelspiegel erstrecken sich dann jeweils über die gesamte Länge eines solchen Laserbarrens, mit denen sich dann beispielsweise Leistungen im Bereich zwischen 100 und 150 W erzielen lassen.

Zur Kühlung werden die Laserbarren üblicherweise mit ihrer p-Seite auf Wärmesenken aufgelötet, und zwar insbesondere auch auf aktive Wärmesenken, d.h. auf Wärmesenken, die bzw. deren Kanäle oder Kanalstrukturen von einem Kühlmedium, beispielsweise von Kühlwasser durchströmt werden.

Bekannt ist hierbei insbesondere, zur Erhöhung der Leistung Diodenlaseranordnungen stapelartig auszubilden, und zwar mit mehreren übereinander angeordneten und jeweils an einer Wärmesenke vorgesehenen Laserbarren.

Nachteilig ist bei bekannten Diodenlaseranordnungen, dass die Kühlung der Laserbarren bzw. der Emitter nur einseitig, d.h. an der Montageseite oder p-Seite erfolgt, während die andere Seite, beispielsweise die n-Seite der Laserchips des Laserbarrens lediglich zur Kontaktierung genutzt wird.

Weiterhin sind speziell die bekannten stapelartig ausgebildeten Diodenlaseranordnungen konstruktiv aufwendig und auch störanfällig, und zwar insbesondere deswegen, weil sich konstruktionsbedingt u.a. zahlreiche Übergangsstellen für das Kühlwasser ergeben, die mit Dichtungen, beispielsweise mit O-Ringen abgedichtet werden müssen. Weiterhin sind auch zahlreiche Übergangsstellen bzw. Anschlüsse für die Stromversorgung erforderlich.

Bekannt ist das sogenannten "DCB-Verfahrens" (Direct-Copper-Bond-Technology) beispielsweise zum Verbinden von Metallschichten oder -blechen (z.B. Kupferblechen oder -folien) mit einander und/oder mit Keramik oder Keramikschichten, und zwar unter Verwendung von Metall- bzw. Kupferblechen oder Metall- bzw. Kupferfolien, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Dieses DCB-Verfahren weist dann z.B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozeßtemperatur zwischen etwa 1025 bis 1083°C, z.B. auf ca. 1071 °C;
- Abkühlen auf Raumtemperatur.

Bekannt ist weiterhin das sogenannte Aktivlot-Verfahren (DE 22 13 115; EP-A-153 618) z.B. zum Verbinden von Metallisierungen bildenden Metallschichten oder Metallfolien, insbesondere auch von Kupferschichten oder Kupferfolien mit Keramikmaterial. Bei diesem Verfahren, welches speziell auch zum Herstellen von Metall-Keramik-Substraten verwendet wird, wird bei einer Temperatur zwischen ca. 800 - 1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Bekannt ist eine Diodenlaseranordnung mit den Merkmalen des Oberbegriffs des Patentanspruchs 1 (JP 2004 146720 A1). Diese bekannte Diodenlaseranordnung weist eine Wärmesenkenanordnung mit mehreren Wärmesenken auf, die jeweils von einer Platte aus einem Wärme leitenden Material gebildet sind. Zwischen jeweils zwei Platten, die durch eine Keramikschicht von einander beabstandet sind, ist ein Spalt zur Aufnahme eines Laserbarrens gebildet ist. Die Keramikschichten sind als aktive Kühler, d.h. mit von einem Kühlmedium durchströmbaren Kanälen ausgebildet.

Bekannte ist weiterhin eine Diodenlaseranordnung mit mehreren Laserbarren und mit einer Wärmesenkenanordnung, die von mehreren Wärmesenken gebildet ist und in der die Laserbarren jeweils zwischen zwei Wärmesenken angeordnet sind (US 6 647 035 B1). Die Wärmesenken bestehen jeweils aus drei Schichten, von denen die mittlere Schicht eine Glasschicht und die beiden äußeren Mikro-Kühlkanäle bildenden Schichten aus Silizium sind. Die Schichten sind durch anodisches Bonden miteinander verbunden. Die Wärmesenken bilden mit weiteren Isolierschicht aus Glas eine Wärmesenkenanordnung, in der jeweils zwei Wärmesenken durch eine Isolierschicht so voneinander beabstandet sind, dass zwischen zwei benachbarten Wärmesenken ein Spalt oder Montagebereich zur Aufnahme eines Laserchips gebildet ist.

Bekannt ist weiterhin eine Laserdiodenanordnung mit einer Wärmesenkenanordnung (EP 1 696 526 A1), die aus mehreren stapelartig übereinander angeordneten

Wärmesenken und aus zwischen den Wärmesenken angeordneten und diese voneinander beabstandenden Zwischenschichten aus Silikongummi besteht. Zwischen benachbarten Wärmesenken ist wiederum ein Spalt oder Montagebereich zur Aufnahme eines Laserchips gebildet.

Aufgabe der Erfindung ist es, eine Diodenlaseranordnung aufzuzeigen, die die Nachteile des Standes der Technik vermeidet und bei verbesserter Kühlwirkung eine vereinfachte Konstruktion ermöglicht.

Zur Lösung dieser Aufgabe ist eine Diodenlaseranordnung entsprechend dem Patentanspruch 1 ausgebildet. Ein Verfahren zum Herstellen einer Diodenlaseranordnung ist Gegenstand des Patentanspruchs 18.

Bei der erfindungsgemäßen Diodenlaseranordnung erfolgt die Kühlung jedes Laserbarrens an zwei Seiten, d.h. sowohl an der n-Seite als auch an der p-Seite der Chips bzw. Emitter. Hierdurch wird nicht nur die Kühlwirkung verbessert, so dass höhere Leistungen möglich sind, sondern durch die beidseitige Kühlung ergibt sich ein thermomechanisch symmetrischer Aufbau, mit dem insbesondere auch negative Einflüsse reduziert werden, die sich aus den Unterschieden des thermischen Ausdehnungskoeffizienten zwischen dem Material der jeweiligen Wärmesenke und dem Halbleitermaterial bzw. dem Material der Zwischenträger ergeben, über die die Laserbarren mit den Wärmesenken verbunden sind.

Bei einer bevorzugten Ausführung der Erfindung ist der jeweilige Laserbarren beidseitig mit jeweils wenigstens einem Zwischenträger oder Submount versehen und bildet somit mit den Submounts eine Laserbarrenanordnung. Als Material für die Zwischenträger oder Trägerschichten, über die der jeweilige Laserbarren mit der angrenzenden Wärmesenke verbunden wird, eignen sich beispielsweise Kupfer/ Wolfram-Legierungen mit einem thermischen Ausdehnungskoeffizienten (CTE) von 6 - 9 ppm/K.

Bei der Erfindung sind die wenigstens zwei Wärmetauscher bzw. Wärmesenken, die beidseitig von dem wenigstens einen Laserbarren oder der wenigstens einen Laserbarrenanordnung vorgesehen sind, sowie die wenigstens eine zwischen den Wärmesenken angeordnete Isolierschicht zu einer monolithischen Wärmesenkenanordnung miteinander verbunden. Monolithisch bedeutet im Sinne der Erfindung, dass diese Verbindung nicht unter Verwendung von mechanischen Verbindungselementen, wie Schrauben, Spannbolzen oder dergleichen Spann- und/oder Verbindungselementen hergestellt ist, sondern durch Material verbindende Verfahren, das DCB- Bonden.

Bei einer bevorzugten Ausführungsform der Erfindung sind an der Ober- und Unterseite der Wärmesenkenanordnung Ausgleichselemente vorgesehen, und zwar bevorzugt in Form von Ausgleichsschichten, und zwar zur Vermeidung von thermischen Verformungen der Wärmesenkenanordnung, insbesondere während der Montage, aber auch während des Betriebes.

Die Wärmesenkenanordnung ist symmetrisch oder im Wesentlichen symmetrisch zu einer Mittelebene ausgeführt. Aufgrund dieses symmetrischen Aufbaus ist auch eine löttechnische Montage bei stark reduziertem Verzug des Laserchips bzw. Laserbarrens (Smile-Effect) möglich, und zwar selbst dann, wenn die Zwischenträger und das Material der Wärmesenken einen deutlich unterschiedlichen Wärmeausdehnungskoeffizienten (CTE) aufweisen.

Die jeweilige aktive Wärmesenke besteht zumindest im Montagebereich des jeweiligen Laserbarrens aus mehreren Metall- oder Kupferschichten, die mittels der DCB-Technik miteinander verbunden sind. Der Ausdehnungskoeffizient der Wärmesenke liegt somit beispielsweise in der Größenordnung von 16 ppm/K und unterscheidet sich daher deutlich von dem Wärmeausdehnungskoeffizienten des Submounts bzw. Zwischenträgers. Durch den symmetrischen Aufbau, d.h. durch die Verwendung zweier Zwischenträger oder Tragschichten beidseitig von dem jeweiligen Laserbarren und einer anschließenden aktiven Wärmesenke ergibt sich trotz einer Löt-Montage der Zwischenträger an den Wärmesenken keine, zumindest aber keine störende, die spätere Strahlformung negativ beeinflussende Verbiegung des Laserchips.

Die Herstellung der erfindungsgemäßen Diodenlaseranordnung erfolgt beispielsweise in der Form, dass die Laserbarren beidseitig jeweils unter Verwendung eines Hartlots, beispielsweise eines AuSn-Lots mit einem Zwischenträger versehen werden und dann zwischen jeweils zwei aktive Wärmetauscher einer diese Wärmetauscher im Stapel aufweisenden Wärmetauscheranordnung eingesetzt und anschließend die Zwischenträger mit den an diese angrenzenden Wärmetauschern verlötet werden. Die beiden beidseitig von dem Laserbarren vorgesehenen Zwischenträger oder Trägerschichten weisen dabei die selben oder zumindest im Wesentlichen die selben Abmessungen und Materialeigenschaften auf, so dass nach dem Lötprozess die angestrebte geradlinige Ausbildung des jeweiligen, beidseitig mit jeweils einem aktiven Wärmetauscher verbundenen Laserbarrens erhalten wird.

Die Abmessungen der Zwischenträger sind an den jeweiligen Laserbarren angepasst, und zwar beispielsweise derart, dass der Auskoppelspiegel des Laserbarrens bündig oder nahezu bündig mit einer Seite oder Kante des jeweiligen Zwischenträgers angeordnet ist, während die Zwischenträger an der gegenüberliegenden Seite beispielsweise über den Laserbarren wegstehen.

Die von den Wärmesenken und den dazwischen angeordneten Isolierschichten gebildete Wärmesenkenanordnung bildet eine monolithische Baueinheit, so dass durch Dichtungen abzudichtende Übergangsstellen für das flüssige Kühlmedium, beispielsweise Kühlwasser entfallen. Über die zumindest im Montagebereich der Laserbarren aus einem metallischen Material bestehenden aktiven Wärmesenken ist auch in besonders einfacher Weise die elektrische Kontaktierung der Laserbarren möglich.

In Weiterbildung der Erfindung besteht die Möglichkeit,
dass der wenigstens eine Laserbarren beidseitig, d.h. sowohl mit seiner n-Seite als auch mit seiner p-Seite jeweils elektrisch mit der zumindest im Montagebereich teilweise aus einem elektrisch leitenden Material bestehenden Wärmesenke verbunden ist,
und/oder
dass in der Verbindung zwischen dem wenigstens einen Laserbarren und der jeweiligen Wärmesenke eine Zwischenschicht oder ein Zwischenträger aus einem zumindest thermisch gut leitenden, vorzugsweise thermisch und elektrisch gut leitenden Material, zur Reduzierung des Einflusses des unterschiedlichen Wärmeausdehnungskoeffizienten zwischen dem Halbleitermaterial des Laserbarrens und dem metallischen Material der Wärmesenke vorgesehen ist
und/oder
dass die Zwischenschicht bzw. der Zwischenträger aus einer CuW-Legierung besteht,
und/oder
dass der wenigstens eine, beidseitig mit Zwischenträgern versehene Laserbarren in dem zwischen den wenigstens zwei Wärmesenken gebildeten Spalt aufgenommen ist,
und/oder
dass der Spalt durch die wenigstens eine Isolierschicht zwischen den wenigstens zwei Wärmesenken gebildet ist,
und/oder
dass die Wärmesenken jeweils aus einer Vielzahl von flächig miteinander verbundenen Schichten besteht, von denen innere Schichten zur Ausbildung einer eine Vielzahl von Kühlkanälen aufweisenden Kühlerstruktur strukturiert sind,
und/oder
dass die die Wärmesenken bildenden Schichten unter Verwendung der DCB-Technik miteinander verbunden sind,
und/oder
dass die wenigstens eine zwischen zwei Wärmesenken angeordnete Isolierschicht eine Keramikschicht, beispielsweise aus Aluminiumoxid- und/oder Aluminiumnitrid ist,
und/oder
dass die wenigstens eine Isolierschicht an wenigstens einer Oberflächenseite mit einer mit der angrenzenden Wärmesenke verbundenen Metallisierung, beispielsweise mit einer diese Metallisierung bildenden Metallschicht oder Metallfolie versehen ist
und/oder
dass die Metallisierung unter Verwendung des DCB-Verfahrens aufgebracht ist,
und/oder
dass die Wärmesenken und die wenigstens eine Isolierschicht unter Verwendung des DCB-Verfahrens mit einander verbunden sind, und/oder
dass sie mehr als zwei stapelartig zu einer Wärmesenkenanordnung verbundene Wärmesenken aufweist,
und/oder
dass in der Wärmesenkenanordnung zwischen zwei jeweils beidseitig von wenigstens einem Laserbarren angeordneten Wärmesenken auch wenigstens eine Isolierschicht (7) vorgesehen ist,
und/oder
dass zwischen jeweils zwei in der Wärmesenkenanordnung aufeinander folgenden Wärmesenken jeweils wenigstens ein Laserbarren vorgesehen ist, und/oder
dass nur zwischen einem Teil der die Wärmesenkenanordnung bildenden Wärmesenken jeweils wenigstens ein Laserbarren angeordnet ist,
und/oder
zwei durch die Wärmesenken und Isolierschichten hindurchreichende Kanäle zum Zuführen und Abführen des Kühlmediums vorgesehen sind,
und/oder
dass auf die eine Ober- und/oder Unterseite bildenden Oberflächenseiten der Wärmesenkenanordnung wenigstens eine Ausgleichsschicht aufgebracht ist, und/oder
dass die wenigstens eine Ausgleichsschicht aus dem Material der wenigstens einen Isolierschicht und/oder aus einem Material besteht, welches denselben oder im Wesentlichen denselben thermischen Ausdehnungskoeffizient wie die wenigstens eine Isolierschicht aufweist,
und/oder
dass die wenigstens eine Ausgleichsschicht aus dem Material der Zwischenträger und/oder aus einem Material besteht, welches denselben oder im Wesentlichen denselben thermischen Ausdehnungskoeffizient wie die Zwischenträger aufweist,
und/oder
dass die wenigstens eine Ausgleichsschicht das gleiche Volumen oder im Wesentlichen das gleiche Volumen wie die wenigstens eine Isolierschicht oder ein Zwischenträger aufweist, beispielsweise hinsichtlich Größe und Dicke identisch oder im Wesentlichen identisch mit der wenigstens einen Isolierschicht oder dem Zwischenträger ist
und/oder
dass die wenigstens eine Ausgleichsschicht in gleicher Weise mit der Wärmesenke verbunden ist wie die an die Wärmesenke anschließende wenigstens eine Isolierschicht oder der an die Wärmesenke anschließende Zwischenträger,
und/oder
dass die Tiefe des zwischen dem wenigstens zwei Wärmesenken gebildeten Spaltes wenigstens 8mm beträgt,
wobei die vorgenannten Merkmale jeweils einzeln oder in beliebiger Kombination vorgesehen sein können.

Weiterbildungen, Vorteile und Anwendungsmöglichkeiten der Erfindung ergeben sich auch aus der nachfolgenden Beschreibung von Ausführungsbeispielen und aus den Figuren.

Die Erfindung wird im Folgenden anhand der Figuren an einem Ausführungsbeispiel näher erläutert. Es zeigen:
- Fig. 1 und 2: eine Diodenlaseranordnung gemäß der Erfindung in Draufsicht sowie in Seitenansicht;
- Fig. 3: in perspektivischer Darstellung einen Laserbarren, zusammen mit zwei auf den Laserbarren aufgebrachten Zwischenträgern;
- Fig. 4: in schematischer Darstellung die Montage des Laserchips zwischen zwei Wärmesenken der Wärmesenkenanordnung;
- Fig. 5: in vergrößerter Teildarstellung die Wärmesenkenanordnung im Bereich zweier benachbarten Wärmesenken an der Rückseite der Diodenlaseranordnung;
- Fig. 6: eine Darstellung ähnlich Figur 2 bei einer weiteren Ausführungsform.

Die in den Figuren allgemein mit 1 bezeichnete Diodenlaseranordnung besteht im Wesentlichen aus mehreren stapelartig übereinander angeordneten Wärmesenken 2 sowie aus mehreren zwischen den Wärmesenken 2 angeordneten und mit diesen auch elektrisch verbundenen Laserbarren 3, die jeweils eine Vielzahl von Laserlicht aussenden Emittern aufweisen.

Im Folgenden sind die Beispiele, die ein DCB-Bonden aufweisen als Ausführungsbeispiele zu verstehen während die Alternative beinhaltend ein Aktiv-Lötverfahren nur als Beispiel zum besseren Verständnis der Erfindung zu verstehen ist. ¶

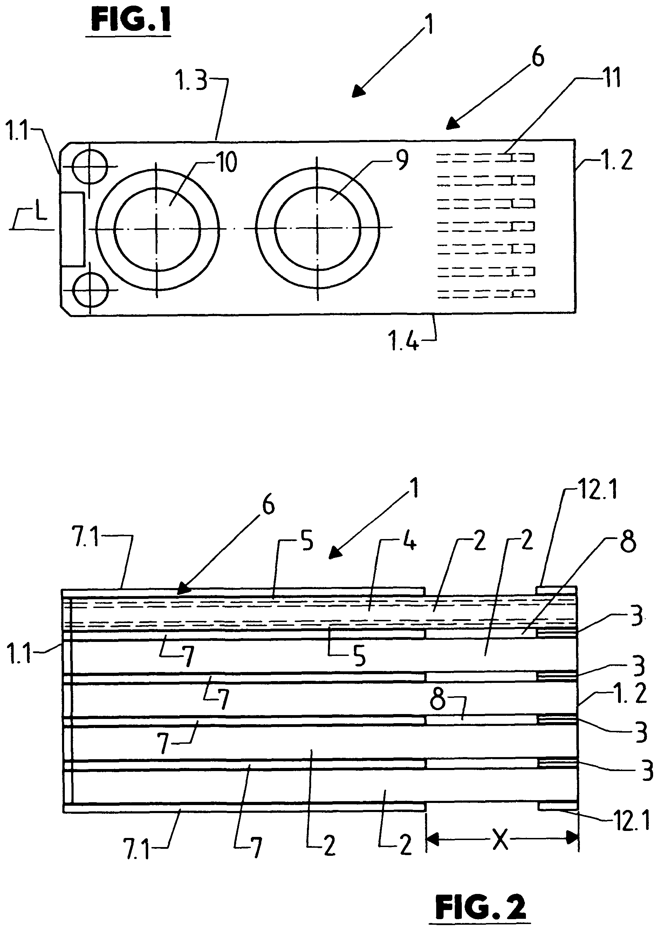

Die Wärmesenken 2 sind aktive Wärmesenken bzw. Kühler (Mikrokühler), die von einem Kühlmedium, beispielsweise Wasser durchströmt werden. Hierfür besteht jede Wärmesenke 2 aus einer Vielzahl von Schichten oder Folien 4 und 5 aus einem Metall, beispielsweise Kupfer. Die Schichten 4 und 5 sind mit einem geeigneten Verfahren, beispielsweise mit der DCB-Technik oder einem Aktiv-Lötverfahren einander verbunden. Die zwischen den äußeren Schichten, d.h. bei der für die Figur 2 gewählten Darstellung zwischen der oberen und unteren Schicht 5 angeordneten Schichten 4 sind jeweils strukturiert, d.h. mit Öffnungen und Durchbrüchen versehen, so dass sich in diesen Schichten Strömungskanäle für das Kühlmedium ergeben, die durch die äußeren Schichten, d.h. bei der für die Figur 2 gewählten Darstellung durch die oberen und unteren Schichten 5 nach außen hin dicht verschlossen sind.

Die bei der dargestellten Ausführungsform in Draufsicht jeweils rechteckförmigen Wärmesenken 2 sind stapelartig übereinander liegend zu einer quaderförmigen Wärmesenkenanordnung 6 miteinander verbunden, und zwar derart, dass jeweils zwischen zwei im Stapel aufeinander folgenden Wärmesenken 2 eine Isolierschicht 7 aus einem elektrisch isolierenden Material vorgesehen ist. Letztere erstreckt sich ausgehend von der die Rückseite 1.1 der Diodenlaseranordnung bildenden Schmalseite der Wärmesenkenanordnung 6 in Richtung auf die die Vorderseite 1.2 der Diodenlaseranordnung 1 bildenden Schmalseite der Wärmesenkenanordnung 6, endet aber mit Abstand von dieser Vorderseite 1.2. Hierdurch ergibt sich im Bereich der Vorderseite 1.2 zwischen zwei benachbarten Wärmesenken 2 ein Spalt 8, der sowohl zu der Vorderseite 1.2 als auch zu den beiden Längsseiten 1.3 und 1.4 der Diodenlaseranordnung 1 hin offen ist.

Die Isolierschichten 7 sind beispielsweise solche aus Keramik, beispielsweise aus einer Aluminiumoxid- und/oder Aluminiumnitrid-Keramik. Weiterhin sind die Isolierschichten 7 in einer geeigneten Technik, beispielsweise unter Verwendung der DCB-Technik oder durch Aktiv- oder Hartlöten mit den Wärmesenken 2 flächig verbunden.

Zum Zuführen des Kühlmediums an die einzelnen Wärmesenken 2 bzw. in die dortigen Kanäle sowie zum Abführen des Kühlmediums aus den Wärmesenken 2 sind in der Wärmesenkenanordnung 6 zwei Kanäle 9 und 10 vorgesehen, die mit ihren Achsen senkrecht zu der Ober- und Unterseite der Wärmesenken 2 sowie senkrecht zu den Isolierschichten 7 orientiert und weiterhin auch in Längsrichtung der Wärmesenken 2 gegeneinander versetzt sind. Mit den Kanälen 9 und 10, von denen beispielsweise der Kanal 9 den Zulauf und der Kanal 10 den Rücklauf für das Kühlmedium bilden, ist die Wärmesenkenanordnung 6 an einen nicht dargestellten Kühlkreislauf angeschlossen. Die Kanäle 9 und 10 sind jeweils von deckungsgleich angeordneten Bohrungen in den Wärmesenken 2 bzw. in den dortigen Lagen 4 und 5 sowie in den Isolierschichten 7 gebildet und innerhalb der Wärmesenken 2 in geeigneter Weise mit den dortigen Kühlkanälen verbunden, die sich bis an die Vorderseite 1.2 der Diodenlaseranordnung 1 erstrecken, wie dies in den Figuren schematisch mit 11 angedeutet ist.

Auf jeden Laserbarren 3 ist beidseitig ein Zwischenträger 12 (auch Submount) aufgebracht, und zwar durch Auflöten mit einem geeigneten Lot, beispielsweise mit einem AuSn-Hartlot. Jeder Zwischenträger 12 ist so ausgebildet, dass er den Laserbarren 3 an einer Oberflächenseite über die gesamte Länge abdeckt, mit einer Längsseite bündig mit der die Auskoppelseite oder den Auskoppelspiegel des Laserbarrens 3 bildenden Längsseite dieses Barrens liegt und mit der gegenüberliegenden Längsseite über die den hoch reflektierenden Endspiegel des Laserbarrens 3 bildende Längsseite geringfügig vorsteht, beispielsweise um einige 100 µm. Jeder Zwischenträger 12 besitzt bei der dargestellten Ausführungsform eine Dicke, die etwas größer ist als die Dicke des Laserbarrens 3 und besteht aus einem Material, über welches ein Ausgleich der unterschiedlichen Wärmeausdehnungskoeffizienten des Metalls (beispielsweise Kupfer) der Wärmesenken 2 und des Halbleitermaterials der Laserbarren 3 erreichbar ist. Als Material für die Zwischenträger eignet sich beispielsweise eine CuW-Legierung.

Jeder beidseitig mit einem Zwischenträger 12 versehene Laserbarren 3 ist in einen Spalt 8 derart eingesetzt, dass die Laserbarren 3 mit ihrer Auskoppelseite senkrecht zur Längserstreckung der Wärmesenken 2 orientiert jeweils bündig oder annähernd bündig mit der Vorderseite 1.2 der Diodenlaseranordnung 1 liegen. Die Zwischenträger 12 sind durch Löten, beispielsweise Hartlöten mit der jeweils benachbarten Wärmesenke 2 verbunden, und zwar sowohl thermisch als auch elektrisch. Über die thermische Verbindung erfolgt eine optimale Kühlung jedes Laserbarrens 3 sowohl an seiner n-Seite als auch an seiner p-Seite, und zwar über die benachbarte aktive Wärmesenke 2 mit den jeweils bis in den Montagebereich der Laserbarren 3 reichenden Kühlkanäle 11. Über die beiden jedem Laserbarren 3 benachbarten und durch die Isolierschicht 7 elektrisch getrennten metallischen Wärmesenken 2 ist eine einfache elektrische Kontaktierung bzw. Versorgung der Laserbarren 3 möglich. Die Laserbarren 3 können hierbei sowohl elektrisch parallel als auch in Serie betrieben werden.

Über die metallischen Zwischenträger 12 erfolgt zugleich auch eine Kontaktierung der einzelnen Emitter jedes Laserbarrens 3 an deren p-Seite und n-Seite.

Die Herstellung der Diodenlaseranordnung 2 erfolgt beispielsweise in der Form, dass zunächst die einzelnen Wärmesenken unter Verwendung der mit den Öffnungen für die Kanäle 9 und 10 und mit der Profilierung für die Kühlkanäle 11 versehenen metallischen Schichten 4 und 5 hergestellt und dann unter Verwendung dieser Wärmesenken 2 und der ebenfalls mit den Durchlässen für die Kanäle 9 und 10 versehenen Isolierschichten 7 die Wärmesenkenanordnungen 6 gefertigt werden.

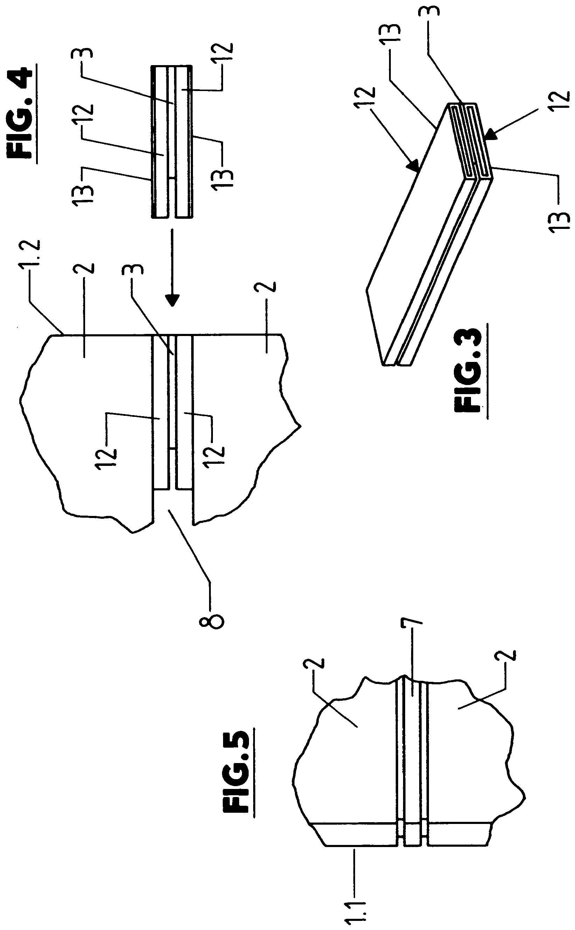

In die Schlitze 8 der jeweiligen Wärmesenkenanordnung 6 werden dann von der Vorderseite 1.2 her die mit den Zwischenschichten 12 versehenen Laserbarren 3 (Figur 3) eingesetzt und dort durch Festklemmen zumindest vorübergehend fixiert, wie dies in der Figur 4 angedeutet ist. Jeder Zwischenträger 12 ist dabei an seiner den Laserbarren 3 abgewandten Oberflächenseite bereits mit einer Lotschicht 13 versehen. Nach dem Einsetzen sämtlicher mit den Zwischenschichten 12 versehener Laserbarren 3 in die Schlitze 8 erfolgt das Verlöten der Zwischenschichten 12 mit den jeweils benachbarten Wärmesenken 2 unter Erhitzen des gesamten Verbundes auf eine über dem Schmelzpunkt der Lotschichten 13 liegenden Temperatur, allerdings ohne dass der Schmelzpunkt des Lotes erreicht wird, welches für die Verbindung zwischen den Laserbarren 3 und den Zwischenträgern 12 verwendet ist.

Die einzelnen Wärmesenken 2 und die zwischen diesen angeordneten Isolierschichten 7 aus Keramik sind über geeignete Verfahren, beispielsweise über Direct-Bonding (DCB-Verfahren) oder Aktiv-Lötverfahren zu einem die Wärmesenkenanordnung 6 bildenden monolithischen Block miteinander verbunden, und zwar in der Form, dass sich ein vollständig spiegelsymmetrischer Aufbau zu einer gedachten Mittelebene ergibt, die in der Mitte zwischen der Ober- und Unterseite der Wärmesenkenanordnung sowie parallel zu diesen Seiten verläuft.

Da jeder Laserbarren 3 beidseitig mit einem Zwischenträger 12 versehen ist und außerdem die Lötverbindung der jedem Laserbarren 3 zugeordneten Zwischenträger mit der jeweils benachbarten Wärmesenke 2 zeitgleich erfolgt, ist bei der Erfindung auch ein Verbiegen bzw. Verformen der Laserbarren 3 um eine oder mehreren Achsen parallel zu deren aktiver Schicht und damit ein unerwünschter Smile-Effekt insbesondere auch beim Abkühlen des für die Lötverbindung verwendeten Lots vermieden. Die beidseitig von jedem Laserbarren 3 vorgesehenen Zwischenträger 12 sind hierfür bevorzugt identisch ausgebildet, zumindest aber so ausgebildet, dass deren Materialvolumen und/oder thermisches Verhalten gleich ist.

Beim Verlöten der in die Schlitze 8 eingesetzten, beidseitig mit jeweils den metallischen Zwischenträger versehenen Laserbarren 3 wird die gesamte Wärmesenkenanordnung 6 erhitzt, beispielsweise auf die Löttemperatur. Durch entsprechende Konstruktion und Materialwahl ist dafür gesorgt, dass keine Veränderungen der Spaltbreite der Schlitze 8 während des Lötprozesses eintreten. Hierdurch wird eine spannungsarme Montage der Laserbarren 3 erreicht. Die Wärmesenken 2 und Isolierschichten 7 besitzen hierfür in der Wärmesenkenanordnung 6 jeweils gleiche Dicke und Größe. Außerdem sind bei der dargestellten Ausführungsform in einer Betrachtungsrichtung senkrecht zur Oberseite der Wärmesenkenanordnung 6 sämtliche Isolierschichten 7 deckungsgleich mit einander vorgesehen. Gleiches gilt auch für die Wärmesenken.

An beiden Enden des die Wärmesenkenanordnung 6 bildenden Stapels sind vorzugsweise Ausgleichselemente vorgesehen sein. Diese Ausgleichselemente verhindern, dass sich die die Ober- und Unterseite der Wärmesenkenanordnung 6 bildenden Elemente, d.h. die dortigen äußeren Wärmesenken 2 beim Erhitzen und dabei insbesondere während des Lötprozesses verformen oder verwölben, und zwar bedingt durch unterschiedliche Wärmeausdehnungskoeffizienten zwischen den äußeren Wärmesenken 2 und der jeweils angrenzenden innen liegenden Isolierschicht 7. Als Ausgleichselemente eignen sich zusätzlich Isolier- bzw. Keramikschichten, die in der Figur 2 bei 7.1 angedeutet sind und die hinsichtlich ihrer Dicke und Formgebung identisch mit den Isolierschichten 7 sind und den inneren Isolierschichten 7 unmittelbar gegenüber liegen.

Durch die zusätzlichen Isolierschichten 7.1 sind auch die äußeren Wärmesenken 2 hinsichtlich der angrenzenden Isolierschichten 7 und 7.1 spiegelsymmetrisch zu einer zwischen den Isolierschichten 7 und 7.1 verlaufenden gedachten Mittelebene ausgebildet, so dass ein temperaturbedingtes Verwölben der äußeren Wärmesenken 2 (durch Bimetalleffekt) und damit eine hieraus resultierende Änderung der Breite des betreffenden Schlitz 8 während des Lötprozesses sowie hieraus resultierende mechanische Belastungen der Laserbarren 3 vermieden sind.

Bevorzugt wird beim Einlöten der mit den Zwischenträgern 12 versehenen Laserbarren 3 auf die Ober- und Unterseite der Wärmesenkenanordnung 6 auch jeweils ein plattenförmiges Ausgleichselement 12.1 aufgelötet, welches hinsichtlich Form, Größe und Material mit den metallischen Zwischenträgern 12 identisch ist. Auch hierdurch werden während des Lötprozesses und insbesondere während des Abkühlens des Lots an beiden Seiten der äußeren Wärmesenken 2 identische Verhältnisse erreicht, die ein temperaturbedingtes Verformen dieser Wärmesenken und damit ein Verformen der Laserbarren 3 verhindern. Jedes Ausgleichselement 12.1 liegt einem Zwischenträger 12 unmittelbar gegenüber.

Um eine Zerstörung oder Beschädigung der Laserbarren 3 durch mechanische Einwirkung zu vermeiden, ist sicher zu stellen, dass nach der Montage der Laserbarren 3 frei von mechanischen Zug- oder Druckkräften ist, auf jeden Fall Zug- und Druckkräfte größer als 20N auf den jeweiligen Laserbarren einwirken. Dies wird in der vorstehend beschriebenen Weise durch die Vermeidung einer temperaturbedingten Verformung oder Verwölbung der Wärmesenkenanordnung 6 insbesondere unter Verwendung der Ausgleichselemente 7.1 und 12.1 erreicht. Wesentlich in diesem Zusammenhang ist aber auch, dass jeder Spalt 8 in Richtung der Längsachse L eine ausreichende Tiefe x aufweist, d.h. dass der Abstand zwischen der Vorderseite 1.2 der Diodenlaseranordnung 1 bzw. der Wärmesenkenanordnung 6 und der dieser Vorderseite zugewandten Seite der Isolierschichten 7 ausreichend groß ist, die Wärmesenken 2 also ausreichend weit über die Isolierschichten 7 vorstehen, so dass die Wärmesenken 2 mit ihrem über die Isolierschicht 7 vorstehenden Bereich zum Ausgleich von mechanischen Spannungen (Zug- oder Druckkräften) während der Montage und während des Betriebes genügend elastisch sind. In diesem Sinne ist die Spalttiefe x bei einer bevorzugten Ausführungsform wenigstens gleich 8mm.

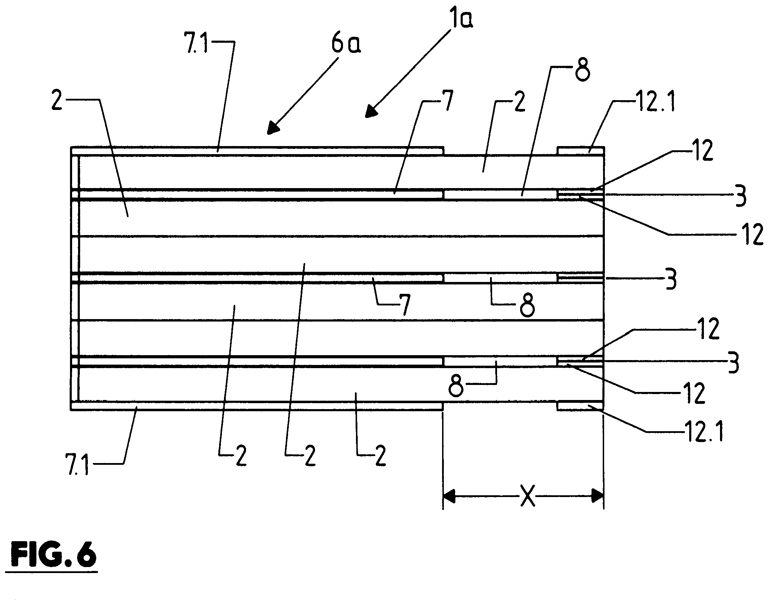

Während vorstehend davon ausgegangen wurde, dass in der stapelartigen Wärmesenkenanordnung 6 jeweils eine Isolierschicht 7 zwischen zwei einander benachbarten Wärmesenken 2 vorgesehen ist, zeigt die Figur 6 als weitere Ausführungsform eine Diodenlaseranordnung 1 a mit einer Wärmesenkenanordnung 6a, bei der im Inneren der stapelartigen Wärmesenkenanordnung jeweils zwei Wärmesenken 2 unmittelbar aneinander anschließen, der Abstand, den zwei Laserbarren 3 an der Vorderseite 1 a.2 der Diodenlaseranordnung voneinander aufweisen, also nicht der einfachen, sondern der doppelten Dicke der Wärmesenken 2 entspricht. Die Laserbarren 3 sind dann bei dieser Ausführungsform jeweils abwechselnd gepolt in den Schlitzen 8 angeordnet, beispielsweise in der Form, dass bei der Darstellung der Figur 6 ausgehend von der Oberseite der oberste Laserbarren 3 mit seiner n-Seite oben liegend, der darunter liegende Laserbarren mit seiner p-Seite oben liegend, der darunter liegende Laserbarren 3 wieder mit seiner n-Seite oben liegend usw. angeordnet sind.

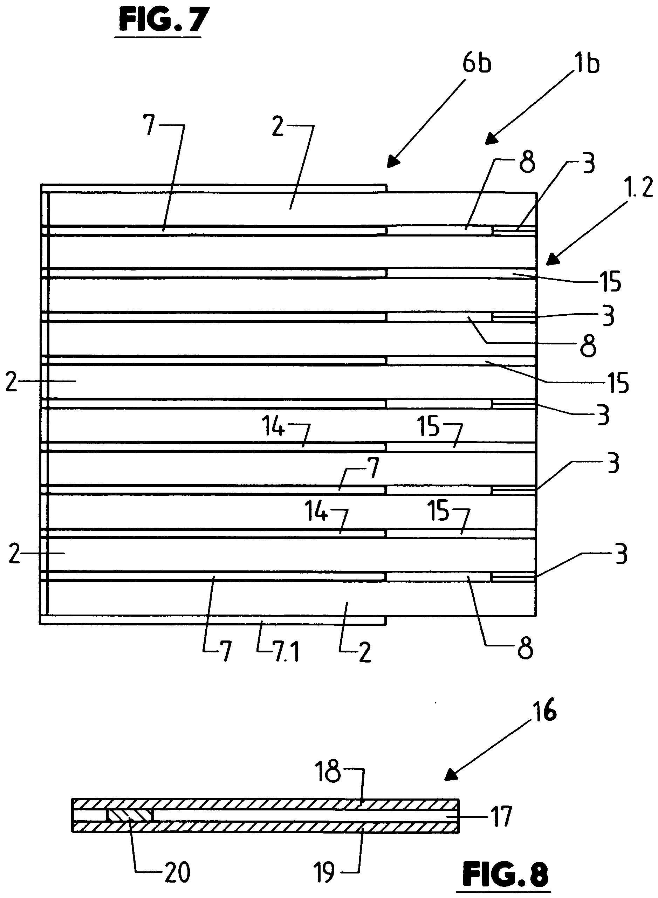

Die Figur 7 zeigt als weitere Ausführungsform eine Diodenlaseranordnung 1 b, die sich von der Diodenlaseranordnung 1 a dadurch unterscheidet, dass in dem die Wärmesenkenanordnung 6b bildenden Stapel zwischen den dort nicht durch eine Isolierschicht 7 voneinander getrennten Wärmesenken 2 jeweils eine dünne Metallschicht 14, beispielsweise eine Kupferschicht vorgesehen ist, die ebenso wie die Isolierschichten 7 mit Abstand x oder einem diesem Abstand entsprechenden Abstand von der Vorderseite 1.2 der Diodenlaseranordnung 1 b bzw. der Wärmesenkenanordnung 6b endet, so dass zwischen den beidseitig von der Metallschicht 14 vorgesehenen Wärmesenken 2 an der Vorderseite 1.2 ein Spalt 15 gebildet ist, der nicht zur Aufnahme eines Laserbarren 3 mit Submounts 12 dient. Jeder Spalt 15 ermöglicht ein elastisches Verformen der angrenzenden Wärmesenke 2 und dient damit ebenfalls einem Ausgleich oder einer Reduzierung von auf die Laserbarren 3 einwirkenden Kräften. An der Vorderseite 1.2 wechseln sich bei dieser Ausführungsform somit Schlitze 8 mit Laserbarren und Submounts 12 mit Schlitzen 15 ab.

Auch die Wärmesenkenanordnung 6b ist an der Oberseite und an der Unterseite mit jeweils einer Ausgleichsschicht 7.1 beispielsweise in Form einer Keramikschicht versehen. Die weiteren Ausgleichsschichten 12.1 sind bei der dargestellten Ausführungsform nicht vorhanden. Grundsätzlich können aber bei der Wärmesenkenanordnung 6b auch derartige Ausgleichsschichten 12.1 zur Herstellung einer vollständigen Symmetrie verwendet sein, und zwar dann nicht nur an der Ober- und Unterseite der Wärmesenkenanordnung 6b, sondern auch in den Schlitzen 15, und zwar an den Wärmesenken 2jeweils gegenüber liegend dem Submount 12 des betreffenden Laserbarrens 3.

Die Figur 8 zeigt in vereinfachter Darstellung und im Schnitt eine Ausgleichsschicht 16, die anstelle der Ausgleichsschichten 7.1 bei den Diodenlaseranordnungen 1, 1 a bzw. 1 b bzw. bei deren Wärmesenkenanordnungen 6, 6a, 6b verwendet werden kann.

Die Ausgleichsschicht 16 ist mehrlagig ausgebildet, d.h. sie besteht jeweils aus einer Schicht 17, die als Ausgleichsschicht dient und hinsichtlich Material, Größe und Dicke identisch mit den Isolierschichten 7 ausgebildet ist, d.h. insbesondere ebenfalls aus de Keramik der Isolierschichten 7 besteht. An ihren Oberflächenseiten ist die Schicht 17 jeweils mit einer Metallisierung 18 und 19, vorzugsweise mit einer Metallisierung aus Kupfer vorgesehen, die mit Hilfe der DCB-Technik oder durch Aktivlöten auf die Schicht 17 aufgebracht ist. Die Metallisierung 18 ist z.B. strukturiert. Weiterhin weist das Ausgleichselement 16 wenigstens eine Durchkontaktierung 20 auf, über die die beiden Metallisierungen 18 und 19 elektrisch miteinander verbunden sind.

Mit der Metallisierung 19 ist das Ausgleichselement 16 jeweils in geeigneter Weise, beispielsweise durch Hartlöten, DCB-Bonden oder auf andere geeignete Weise mit der Außenfläche der Wärmesenke 2 an der Oberseite bzw. Unterseite der Wärmesenkenanordnung 6, 6a, 6b verbunden. Es versteht sich, dass aus Gründen der Symmetrie bei Verwendung des Ausgleichselementes 16 an der Oberseite der Wärmesenkenanordnung ein Ausgleichselement 16 auch an der Unterseite der Wärmesenkenanordnung vorgesehen ist. Die Metallisierungen 18 der beiden Ausgleichselemente 16 bilden bei dieser Ausführung u.a. Anschlüsse zum Zuführen und Abführen des elektrischen Stromes zum Betrieb der Laserbarren 3 bzw. der von diesen Laserbarren 3 gebildeten Emitter.

Abweichend ist es auch möglich, die Ausgleichsschichten 7.1 jeweils an ihrer der Wärmesenkenanordnung 6, 6a, 6b abgewandten Oberflächenseite mit der Metallisierung 18 zu versehen, die dann über eine der Durchkontaktierung 20 entsprechende Durchkontaktierung elektrisch mit der anschließenden, aus einem elektrisch leitenden Material bzw. Metall (z. B. Kupfer) bestehenden Wärmesenke 2 elektrisch verbunden ist, so dass die Metallisierung 19 entfällt.

Durch die Verwendung der Metallisierungen 18 und 19 an den beiden Oberflächenseiten der Schicht 1 7 ist auch das Ausgleichselement 16 für sich genommen symmetrisch aufgebaut und unterliegt somit keinen thermisch bedingten Verformungen.

Ebenso wie bei den Diodenlaseranordnungen 1 und 1 a sind auch bei der Diodenlaseranordnung 1 b die beidseitig von einem Laserbarren 3 und den zugehörigen Submounts 12 vorgesehenen Wärmesenken 2 identisch, insbesondere auch hinsichtlich des verwendeten Materials, Größe sowie Dicke der Wärmesenke.

Bei der Diodenlaseranordnung 1, 1 a oder 1 b besteht weiterhin die Möglichkeit, das Lot zwischen dem jeweiligen Submount 12 und der benachbarten Wärmesenke 2 für einen Toleranzausgleich zu nutzen, beispielsweise einen Toleranzausgleich im Bereich zwischen 2 und 50 µm.

Vorstehend wurden der einfacheren Darstellung wegen Diodenlaseranordnungen gezeigt, die eine begrenzte Anzahl von Schlitzen 8 und damit eine begrenzte Anzahl von Laserbarren 3 aufweisen. Bevorzugt ist die Anzahl der Schlitze 8 mit Laserbarren 7 so gewählt, dass die jeweilige Diodenlaseranordnung 1, 1 a bzw. 1 b insgesamt 4 - 15 Schlitze 8 mit Laserbarren 3 aufweist.

Der elektrische Anschluss der Diodenlaseranordnung 1, 1 a bzw. 1 b an eine nicht dargestellte elektrische Spannungsversorgung erfolgt entweder über die äußeren Wärmesenken oder über die Metallisierungen oder Metallschichten 18 der Ausgleichselemente 16 oder über den Metallschichten 18 entsprechende Metallisierungen auf den Ausgleichsschichten 7.1.

Vorstehend wurde davon ausgegangen, dass bei der Fertigung der Laserdiodenanordnung 1 bzw. 1 a zunächst gesondert die jeweilige Wärmesenkenanordnung 6 bzw. 6a hergestellt wird, dann die jeweils beidseitig mit den Zwischenträgern 12 versehenen Laserbarren 3 in die Schlitze 8 eingesetzt und die Zwischenträger über die Lotschicht 13 mit den angrenzenden Wärmesenken 2 verbunden werden.

Eine weitere Möglichkeit der Herstellung besteht darin, dass die Laserbarren 3 jeweils beidseitig unter Verwendung eines geeigneten Lots, beispielsweise des AuSn-Hartlots, mit den Zwischenträgern 12 versehen werden, dass dann in einem einzigen Arbeitsgang (z.B. Hartlötprozess) die Verbindung der Zwischenträger 12 mit den benachbarten Wärmesenken 2 sowie auch die Verbindung der Wärmesenken 2 und Isolierschichten 7 zu der Wärmesenkenanordnung 6 oder 6a erfolgt, und zwar unter Verwendung jeweils eines Lots (Hartlot), welches einen gegenüber dem Lot der Lötverbindung zwischen den Laserbarren 3 und den Zwischenträgern 12 niedrigeren Schmelzpunkt aufweist, und durch Erhitzen der von den Wärmesenken 2, den Isolierschichten 7 und den Laserbarren 3 mit den Zwischenträgern 12 gebildeten Stapelanordnung. Diese ist hierbei durch wenigstens ein Gewicht beschwert oder auf andere Weise zusammen gehalten, und zwar derart, dass nach dem Löten die Dicke der Lotschicht zwischen jedem Zwischenträger 12 und der angrenzenden Wärmesenke 2 möglichst dünn ist, d.h. überschüssiges Lot dort während des Lötprozesses durch die Beschwerung seitlich abläuft, während innerhalb der Wärmesenkenanordnung 6 oder 6a über die Dicke der Lotschichten ein Ausgleich von Toleranzen erreicht ist. Ein Vorteil dieses Verfahrens besteht darin, dass die Dicke der die Zwischenträger 12 mit jeweils einer Wärmesenke 2 verbindenden Lotschicht extrem klein gehalten wird, hier also für die Kühlung der Laserbarren 3 ein optimaler Wärmeübergang erreicht ist, während die Dicke der Lotschichten innerhalb der Wärmesenkenanordnung 6 bzw. 6a keinen, zumindest aber keinen merkbaren Einfluss auf die Kühlwirkung hat, da die Kühlung der Laserbarren 3 ausschließlich über die beidseitig von jedem Laserbarren vorgesehenen Wärmesenken 2 erfolgt.

Bei dem vorgenannten Verfahren besteht zur Vereinfachung der Handhabung auch die Möglichkeit, die Isolierschichten 7 bereits auf den Wärmesenken 2 vorzubereiten, und zwar durch einseitiges Bonden jeder Isolierschicht 7 an einer Wärmesenke 2, beispielsweise mit Hilfe des DCB-Verfahrens oder eines Aktiv-Lötverfahrens usw.

Die Erfindung wurde voranstehend an Ausführungsbeispielen beschrieben. Es versteht sich, dass Änderungen sowie Abwandlungen möglich sind, ohne dass dadurch der der Erfindung zugrunde liegende Erfindungsgedanke verlassen wird. So ist es beispielsweise möglich, die zwischen den Wärmesenken 2 angeordneten Isolierschichten, beispielsweise Keramikschichten so auszuführen, dass sie an wenigstens einer Oberflächenseite mit einer Metallisierung versehen sind, und zwar in Form einer Metall- oder Kupferfolie, die mittels des DCB-Prozesses oder durch Aktivlöten auf die entsprechende Keramikschicht aufgebracht ist.

Weiterhin besteht bei der Ausführungsform der Figur 6 die Möglichkeit, die jeweils unmittelbar, d.h. ohne Isolierschicht 7 aneinander anschließenden Wärmesenken 2 zu einer gemeinsamen Wärmesenke zusammen zu fassen.

Die Anzahl der Laserbarren 3 und der Wärmesenken 2 kann auch angepasst an die jeweilige Verwendung beliebig gewählt werden. Insbesondere ist es auch möglich, die Diodenlaseranordnung so herzustellen, dass zwischen zwei benachbarten Wärmesenken 2 jeweils mehrere Laserbarren 3 aneinander anschließend oder aufeinander folgend angeordnet sind. Weiterhin besteht auch die Möglichkeit, die Diodenlaseranordnung so herzustellen, dass sie lediglich einen oder mehrere Laserbarren zwischen zwei benachbarten Wärmesenken aufweist.

Weiterhin besteht die Möglichkeit, die Wärmesenkenanordnung 6 bzw. 6a an der Ober- und/oder Unterseite jeweils mit einer weiteren Schicht, beispielsweise mit einer Metallisierung oder Isolierschicht zu versehen.

### Bezugszeichenliste

- 1, 1a: Diodenlaseranordnung
- 1.1: Rückseite
- 1.2, 1 a.2: Vorderseite
- 1.3, 1.4: Längsseite
- 2: als aktiver Kühler ausgebildete Wärmesenke
- 3: Laserbarren
- 4, 5: Schicht der Wärmesenke 2
- 6, 6a: Wärmesenkenanordnung
- 7: Isolierschicht bzw. Keramikschicht
- 7.1: Ausgleichsschicht
- 8: Schlitz
- 9, 10: Kanal zum Zuführen und Abführen des Kühlmediums
- 11: Kühlkanäle
- 12: Zwischenträger oder Submount
- 12.1: Ausgleichsschicht
- 13: Lotschicht
- 14: Kupferschicht
- 15: Ausgleichsschlitz
- 16: Ausgleichselement
- 17: Ausgleichsschicht
- 18, 19: Metallisierung
- 20: Durchkontaktierung

- L: Längserstreckung der Wärmesenken 2
- x: Spalttiefe

## Patentansprüche

1. Diodenlaseranordnung mit jeweils zumindest einen Emitter aufweisenden Laserbarren (3) und mit einer Wärmesenkenanordnung (6, 6a, 6b), die zum Kühlen der Laserbarren (3) von mehr als zwei metallischen Wärmesenken (2) gebildet ist,
wobei die Laserbarren (3) jeweils beidseitig thermisch und elektrisch mit jeweils einer Wärmesenke (2) verbunden sind,
wobei die Wärmesenken (2) mit einander über wenigstens eine Isolierschicht (7), die von einer Keramikschicht, beispielsweise von einer Keramikschicht aus Aluminiumoxid
und/oder Aluminiumnitrid gebildet ist, zu einer monolithischen Wärmesenkenanordnung (6, 6a, 6b) verbunden sind, in der zwischen zwei Wärmesenken (2) jeweils ein Spalt (8) gebildet ist, in dem wenigstens ein Laserbarren (3) angeordnet ist, und wobei zwischen den in der Wärmesenkenanordnung (6) aufeinander folgenden Wärmesenken (2) jeweils wenigstens ein Laserbarren (3) vorgesehen ist,
**dadurch gekennzeichnet,**
**dass** die beidseitig von jedem Laserbarren (3) angeordneten metallischen Wärmesenken (2) jeweils zumindest in einem Montagebereich der Laserbarren (3) als aktive Kühler ausgebildet sind und aus einer Vielzahl von flächig miteinander verbundenen Metallschichten bestehen, die durch DCB-Bonden miteinander verbunden sind und von denen innere Metallschichten (4) zur Ausbildung einer eine Vielzahl von Kühlkanälen (11) aufweisenden Kühlerstruktur strukturiert sind, und
**dass** die Wärmesenken (2) und die wenigstens eine Isolierschicht (7) durch DCB-Bonden mit einander verbunden sind.

2. Diodenlaseranordnung nach Anspruch 1, **dadurch gekennzeichnet, dass** der elektrische Anschluss der Diodenlaseranordnung über die äußeren Wärmesenken der Wärmesenkenanordnung (6) erfolgt.

3. Diodenlaseranordnung nach Anspruch 1 oder 2, **dadurch gekennzeichnet, dass** in der Verbindung zwischen dem wenigstens einen Laserbarren (3) und der jeweiligen Wärmesenke (2) eine Zwischenschicht oder ein Zwischenträger (12) aus einem zumindest thermisch gut leitenden, vorzugsweise thermisch und elektrisch gut leitenden Material, beispielsweise aus einer CuW-Legierung, zur Reduzierung des Einflusses des unterschiedlichen Wärmeausdehnungskoeffizienten zwischen dem Halbleitermaterial des Laserbarrens und dem metallischen Material der Wärmesenke vorgesehen ist.

4. Diodenlaseranordnung nach Anspruch 3, **dadurch gekennzeichnet, dass** der wenigstens eine, beidseitig mit Zwischenträgern (12) versehene Laserbarren (3) in dem zwischen den wenigstens zwei Wärmesenken (2) gebildeten Spalt (8) aufgenommen ist, der vorzugsweise durch die wenigstens eine Isolierschicht (7) zwischen den wenigstens zwei Wärmesenken (2)gebildet ist.

5. Diodenlaseranordnung nach einem der vorhergehenden Ansprüche, **dadurch gekennzeichnet, dass** die wenigstens eine Isolierschicht (7) an wenigstens einer Oberflächenseite mit einer mit der angrenzenden Wärmesenke (2) verbundenen Metallisierung, beispielsweise mit einer diese Metallisierung bildenden Metallschicht oder Metallfolie versehen ist, und dass die die Metallisierung bildende Metallschicht oder Metallfolie durch DCB-Bonden aufgebracht ist.

6. Diodenlaseranordnung nach einem der vorhergehenden Ansprüche, **dadurch gekennzeichnet, dass** sie mehr als zwei stapelartig zu einer Wärmesenkenanordnung (6, 6a, 6b) verbundene Wärmesenken (2) aufweist, wobei beispielsweise in der Wärmesenkenanordnung (6, 6a, 6b) beispielsweise zwischen zwei jeweils beidseitig von wenigstens einem Laserbarren (3) angeordneten Wärmesenken (2) auch wenigstens eine Isolierschicht (7) vorgesehen ist,
und/oder
wobei beispielsweise nur zwischen einem Teil der die Wärmesenkenanordnung (6a) bildenden Wärmesenken (2) jeweils wenigstens ein Laserbarren (3) angeordnet ist,
und/oder wobei beispielsweise wenigstens zwei durch die Wärmesenken (2) und Isolierschichten (7) hindurchreichende Kanäle (10) zum Zuführen und Abführen des Kühlmediums vorgesehen sind.

7. Diodenlaseranordnung nach einem der vorhergehenden Ansprüche, **dadurch gekennzeichnet, dass** auf die eine Ober- und/oder Unterseite bildenden Oberflächenseiten der Wärmesenkenanordnung (6, 6a, 6b) wenigstens ein Ausgleichselement (16) oder wenigstens eine Ausgleichsschicht (7.1, 12.1, 17) aufgebracht ist.

8. Diodenlaseranordnung nach Anspruch 7, **dadurch gekennzeichnet, dass** das wenigstens eine Ausgleichselement (16) oder die wenigstens eine Ausgleichsschicht (7.1, 17) aus dem Material der wenigstens einen Isolierschicht (7) und/oder aus einem Material besteht, welches denselben oder im Wesentlichen denselben thermischen Ausdehnungskoeffizient wie die wenigstens eine Isolierschicht (7) aufweist.

9. Diodenlaseranordnung nach Anspruch 7, **dadurch gekennzeichnet, dass** die wenigstens eine Ausgleichsschicht (12.1) aus dem Material der Zwischenträger (12) und/oder aus einem Material besteht, welches denselben oder im Wesentlichen denselben thermischen Ausdehnungskoeffizient wie die Zwischenträger (12) aufweist.

10. Diodenlaseranordnung nach Anspruch 7 - 9, **dadurch gekennzeichnet, dass** das wenigstens eine Ausgleichselement (16) oder die wenigstens eine Ausgleichsschicht (7.1, 12.1, 17) das gleiche Volumen oder im Wesentlichen das gleiche Volumen wie die wenigstens eine Isolierschicht (7) oder ein Zwischenträger (12) aufweist, beispielsweise hinsichtlich Größe und Dicke identisch oder im Wesentlichen identisch mit der wenigstens einen Isolierschicht (7) oder dem Zwischenträger (12) ist.

11. Diodenlaseranordnung nach einem der Ansprüche 7 - 10, **dadurch gekennzeichnet, dass** das wenigstens eine Ausgleichselement (16) oder die wenigstens eine Ausgleichsschicht (7.1, 12.1, 17) in gleicher Weise mit der Wärmesenke (2) verbunden ist wie die an die Wärmesenke (2) anschließende wenigstens eine Isolierschicht (7) oder der an die Wärmesenke (2) anschließende Zwischenträger (12).

12. Diodenlaseranordnung nach einem der vorhergehenden Ansprüche, **dadurch gekennzeichnet, dass** die Tiefe (x) des zwischen den wenigstens zwei Wärmesenken (2) gebildeten Spaltes (8) wenigstens 8mm beträgt.

13. Diodenlaseranordnung nach einem der Ansprüche 7 - 12, **dadurch gekennzeichnet, dass** das Ausgleichselement (16) mehrschichtig ausgebildet ist, und zwar bestehend aus der Ausgleichsschicht (17) und wenigstens einer Metallisierung (18) auf einer der Wärmesenkenanordnung (6, 6a, 6b) abgewandten Oberflächenseite der Ausgleichsschicht (17), und dass diese Metallisierung (18) wenigstens eine Durchkontaktierung (20) mit der angrenzenden Wärmesenke (2) verbunden ist.

14. Diodenlaseranordnung nach Anspruch 7, **dadurch gekennzeichnet, dass** die Ausgleichsschicht (17) auch an ihrer mit der Wärmesenkenanordnung (6, 6a, 6b) verbundenen Oberflächenseite mit einer Metallisierung (19) versehen ist.

15. Diodenlaseranordnung nach einem der vorhergehenden Ansprüche, **dadurch gekennzeichnet, dass** in der Wärmesenkenanordnung (6, 6b) zwischen wenigstens zwei Wärmesenken (2) ein Ausgleichsschlitz (15) gebildet ist, in welchem kein Laserbarren (3) oder eine von wenigstens einem Laserbarren und Zwischenträgern (12) gebildete Laserbarrenanordnung vorgesehen ist, und dass sich an der Vorderseite (1, 2) Spalten (8) mit Laserbarren (3) oder Laserbarrenanordnungen und Ausgleichsschlitze (15) abwechseln.

16. Diodenlaseranordnung nach einem der vorhergehenden Ansprüche, **dadurch gekennzeichnet, dass** die Anzahl der Spalten (8) mit Laserbarren (3) oder Laserbarrenanordnungen im Bereich zwischen 4 und 15 liegt.

17. Diodenlaseranordnung nach einem der Ansprüche 3 - 16, **dadurch gekennzeichnet, dass** über ein den jeweiligen Zwischenträger (12) mit der angrenzenden Wärmesenke (2) verbindendes Lot ein Toleranzausgleich im Bereich zwischen 2 und 50µm gebildet ist.

18. Verfahren zum Herstellen einer Diodenlaseranordnung mit Laserbarren(3), die jeweils zumindest einen Emitter aufweisen und beidseitig mit jeweils einem metallischen Zwischenträger (12) versehen sind, und mit einer Wärmesenkenanordnung (6, 6a, 6b) zum Kühlen des wenigstens einen Laserbarrens (3),
wobei durch Verbinden von mehr als zwei Wärmesenken (2) über Isolierschichten (7), die von Keramikschichten, beispielsweise von Keramikschichten aus Aluminiumoxid- und/oder Aluminiumnitrid gebildet sind, durch DCB-Bonden eine monolithische Wärmesenkenanordnung (6, 6a, 6b) erzeugt wird, in der zwischen zwei Wärmesenken (2) jeweils wenigstens eine Isolierschicht (7) vorgesehen ist, und hierbei als Wärmesenken (2) aktive Kühler verwendet werden, die jeweils aus einer Vielzahl von flächig miteinander verbundenen Metallschichten erzeugt sind, die durch DCB-Bonden miteinander verbunden sind und von denen innere Metallschichten (4) zur Ausbildung einer eine Vielzahl von Kühlkanälen (11) aufweisenden Kühlerstruktur strukturiert sind, und
wobei anschließend zwischen den in der Wärmesenkenanordnung (6) aufeinander folgenden Wärmesenken (2) jeweils wenigstens ein Laserbarren (3) mit an diesem vorgesehenen Zwischenträgern (12) zwischen zwei Wärmesenken (2)eingesetzt wird und dann die Zwischenträger (12) mit jeweils einer Wärmesenke (2) an deren Montagebereich verbunden werden.

19. Verfahren nach Anspruch 18, **dadurch gekennzeichnet, dass** die Wärmesenkenanordnung (6, 6a, 6b) mit einer Vielzahl von Montagebereichen zur Aufnahme jeweils wenigstens eines mit den Zwischenträgern (12) versehenen Laserbarrens (3) hergestellt wird.

## Claims

1. A diode laser arrangement with laser bars (3) each comprising at least one emitter and with a heat sink arrangement (6, 6a, 6b), which is formed by more than two metallic heat sinks (2) for cooling the laser bars (3),
wherein the laser bars (3) are each connected thermally and electrically on both sides in each case to a heat sink (2),
wherein the heat sinks (2) are connected to one another by at least one insulating layer (7), which is formed by a ceramic layer, for example by a ceramic layer of aluminium oxide and/or aluminium nitride, to form a monolithic heat sink arrangement (6, 6a, 6b), in which a gap (8) is formed in each case between two heat sinks (2), in which gap at least one laser bar (3) is arranged, and wherein at least one laser bar (3) is provided in each case between the heat sinks (2) following one another in the heat sink arrangement (6),
**characterised in that**
the metallic heat sinks (2) arranged on both sides of each laser bar (3) are constituted in each case as active coolers at least in an assembly region of the laser bars (3) and comprise a multiplicity of metal layers planely connected to one another, which metal layers are connected to one another by DCB bonding and inner metal layers (4) of which are structured for the formation of a cooler structure comprising a multiplicity of cooling channels (11), and
that the heat sinks (2) and the at least one insulating layer (7) are connected to one another by DCB bonding.

2. The diode laser arrangement according to claim 1, **characterised in that** the electrical connection of the diode laser arrangement takes place via the outer heat sinks of the heat sink arrangement (6).

3. The diode laser arrangement according to claim 1 or 2, **characterised in that** an intermediate layer or intermediate carrier (12) made of an at least thermally highly conductive, preferably thermally and electrically highly conductive material, for example a CuW alloy, is provided in the connection between the at least one laser bar (3) and the respective heat sink (2) in order to reduce the influence of the different thermal expansion coefficients between the semiconductor material of the laser bar and the metallic material of the heat sink.

4. The diode laser arrangement according to claim 3, **characterised in that** the at least one laser bar (3) provided on both sides with intermediate carriers (12) is accommodated in the gap (8) formed between the at least two heat sinks (2), which gap is preferably formed by the at least one insulating layer (7) between the at least two heat sinks (2).

5. The diode laser arrangement according to any one of the preceding claims, **characterised in that** the at least one insulating layer (7) is provided on at least one surface side with a metallisation connected to the adjacent heat sink (2), for example with a metal layer or metal foil forming this metallisation, and **in that** the metal layer or metal foil forming the metallisation is applied by DCB bonding.

6. The diode laser arrangement according to any one of the preceding claims, **characterised in that** it comprises more than two heat sinks (2) connected in a stack-like manner to form a heat sink arrangement (6, 6a, 6b), wherein for example at least one insulating layer (7) is also provided in the heat sink arrangement (6, 6a, 6b) for example between two heat sinks (2) arranged in each case on both sides of at least one laser bar (3), and/or wherein for example at least one laser bar (3) is arranged in each case only between a part of the heat sinks (2) forming the heat sink arrangement (6a), and/or wherein for example at least two channels (10) are provided for supplying and discharging the cooling medium, said channels extending through the heat sinks (2) and insulating layers (7).

7. The diode laser arrangement according to any one of the preceding claims, **characterised in that** at least one compensation element (16) or at least one compensation layer (7.1, 12.1, 17) is deposited on the surface sides of the heat sink arrangement (6, 6a, 6b) forming an upper and/or a lower side.

8. The diode laser arrangement according to claim 7, **characterised in that** the at least one compensation element (16) or the at least one compensation layer (7.1, 17) is made of the material of the at least one insulating layer (7) and/or of a material which has the same or essentially the same thermal expansion coefficient as the at least one insulating layer (7).

9. The diode laser arrangement according to claim 7, **characterised in that** the at least one compensation layer (12.1) is made of the material of the intermediate carrier (12) and/or of a material which has the same or essentially the same thermal expansion coefficient as the intermediate carrier (12).

10. The diode laser arrangement according to claim 7 - 9, **characterised in that** the at least one compensation element (16) or the at least one compensation layer (7.1, 12.1, 17) has the same volume or essentially the same volume as the at least one insulating layer (7) or an intermediate layer (12), for example is identical or essentially identical in respect of size and thickness to the at least one insulating layer (7) or the intermediate carrier (12).

11. The diode laser arrangement according to any one of claims 7 - 10, **characterised in that** the at least compensation element (16) or the at least one compensation layer (7.1, 12.1, 17) is connected to the heat sink (2) in the same way as the at least one insulating layer (7) adjoining the heat sink (2) or the intermediate layer (12) adjoining the heat sink (2).

12. The diode laser arrangement according to any one of the preceding claims, **characterised in that** the depth (x) of the gap (8) formed between the at least two heat sinks (2) amounts to at least 8 mm.

13. The diode laser arrangement according to any one of claims 7 - 12, **characterised in that** the compensation element (16) is constituted multi-layered, and more precisely comprising the compensation layer (17) and at least one metallisation (18) on a surface side of the compensation layer (17) facing away from the heat sink arrangement (6, 6a, 6b), and **in that** this matallisation (18) is connected by at least one through-connection (20) to the adjacent heat sink (2).

14. The diode laser arrangement according to claim 7, **characterised in that** the compensation layer (17) is also provided with a metallisation (19) on its surface side connected to the heat sink arrangement (6, 6a, 6b).

15. The diode laser arrangement according to any one of the preceding claims, **characterised in that** a compensation slot (15) is formed in the heat sink arrangement (6, 6b) between at least two heat sinks (2), in which compensation slot no laser bar (3) or a laser bar arrangement formed by at least one laser bar and intermediate carriers (12) is provided, and that the gaps (8) alternate with laser bars (3) or laser bar arrangements and compensation slots (15) at the front side (1, 2).

16. The diode laser arrangement according to any one of the preceding claims, **characterised in that** the number of gaps (8) with laser bars (3) or laser bar arrangements lies in the range between 4 and 15.

17. The diode laser arrangement according to any one of claims 3 - 16, **characterised in that** a tolerance compensation in the range between 2 and 50 µm is formed by means of a solder connecting the respective intermediate carrier (12) to the adjacent heat sink (2).

18. A method for producing a diode laser arrangement with laser bars (3), which each comprise at least one emitter and are provided on both sides with a metallic intermediate carrier (12), and with a heat sink arrangement (6, 6a, 6b) for cooling the at least one laser bar (3),
wherein a monolithic heat sink arrangement (6, 6a, 6b) is produced by connecting, by DCB bonding, more than two heat sinks (2) by insulating layers (7), which are formed by ceramic layers, for example ceramic layers of aluminium oxide and/or aluminium nitride, in which monolithic heat sink arrangement at least one insulating layer (7) is provided in each case between two heat sinks (2), and active coolers are hereby used as heat sinks (2), which are each produced from a multiplicity of metal layers planely connected to one another, which metal layers are connected to one another by DCB bonding and inner metal layers (4) of which are structured for the formation of a cooler structure comprising a multiplicity of cooling channels (11), and wherein, between the heat sinks (2) following one another in the heat sink arrangement (6), at least one laser bar (3) with intermediate carriers (12) provided thereon is then inserted in each case between two heat sinks (2), and the intermediate carriers (12) are then each connected to a heat sink (2) in their assembly region.

19. The method according to claim 18, **characterised in that** the heat sink arrangement (6, 6a, 6b) is produced with a multiplicity of assembly regions for accommodating in each case at least one laser bar (3) provided with the intermediate carriers (12).

## Revendications

1. Dispositif laser à diodes avec respectivement des barreaux laser (3) présentant au moins un émetteur et avec un agencement de puits de chaleur (6, 6a, 6b) formé pour le refroidissement des barreaux laser (3) de plus de deux puits de chaleur (2) métalliques,
dans lequel les barreaux laser (3) sont respectivement reliés des deux côtés de façon thermique et électrique à respectivement un puits de chaleur (2),
dans lequel les puits de chaleur (2) sont reliés les uns aux autres par l'intermédiaire d'au moins une couche d'isolation (7), laquelle est formée par une couche de céramique, par exemple par une couche de céramique en oxyde d'aluminium et/ou nitrure d'aluminium, en un agencement de puits de chaleur monolithique (6, 6a, 6b) dans lequel respectivement un écartement (8) est formé entre deux puits de chaleur (2), dans lequel écartement au moins un barreau laser (3) est disposé, et dans lequel on prévoit respectivement au moins un barreau laser (3) entre les puits de chaleur (2) successifs dans l'agencement de puits de chaleur (6),
**caractérisé en ce que**
les puits de chaleur (2) métalliques disposés des deux côtés de chaque barreau laser (3) sont respectivement réalisés en tant que refroidisseurs actifs au moins dans une zone de montage des barreaux laser (3) et se composent d'une pluralité de couches métalliques reliées en nappe les unes aux autres, lesquelles sont reliées les unes aux autres par collage DCB et dont des couches métalliques intérieures (4) sont structurées pour la réalisation d'une structure de refroidisseur présentant une pluralité de canaux de refroidissement (11), et
**en ce que** les puits de chaleur (2) et l'au moins une couche d'isolation (7) sont reliés les uns aux autres par collage DCB.

2. Dispositif laser à diodes selon la revendication 1, **caractérisé en ce que** le raccordement électrique du dispositif laser à diodes s'effectue via les puits de chaleur extérieurs de l'agencement de puits de chaleur (6).

3. Dispositif laser à diodes selon la revendication 1 ou 2, **caractérisé en ce que**, dans la liaison entre l'au moins un barreau laser (3) et le puits de chaleur (2) respectif, on prévoit une couche intermédiaire ou un support intermédiaire (12) en un matériau au moins à bonne conductivité thermique, de préférence à bonne conductivité thermique et électrique, par exemple en un alliage de CuW, pour la réduction de l'influence du coefficient de dilatation thermique différent entre le matériau semi-conducteur du barreau laser et le matériau métallique du puits de chaleur.

4. Dispositif laser à diodes selon la revendication 3, **caractérisé en ce que** l'au moins un barreau laser (3) doté des deux côtés de supports intermédiaires (12) est réceptionné dans l'écartement (8) formé entre les au moins deux puits de chaleur (2), lequel écartement est de préférence formé par l'au moins une couche d'isolation (7) entre les au moins deux puits de chaleur (2).

5. Dispositif laser à diodes selon l'une des revendications précédentes, **caractérisé en ce que** l'au moins une couche d'isolation (7) est dotée, sur au moins un côté de surface, d'une métallisation en liaison avec le puits de chaleur (2) adjacent, par exemple d'une couche métallique ou feuille métallique formant cette métallisation, et **en ce que** la couche métallique ou feuille métallique formant la métallisation est appliquée par collage DCB.

6. Dispositif laser à diodes selon l'une des revendications précédentes, **caractérisé en ce qu'**il présente plus de deux puits de chaleur (2) reliés de façon empilée en un agencement de puits de chaleur (6, 6a, 6b), dans lequel on prévoit, par exemple dans l'agencement de puits de chaleur (6, 6a, 6b), par exemple entre deux puits de chaleur (2) respectivement disposés des deux côtés d'au moins un barreau laser (3), également au moins une couche d'isolation (7), et/ou dans lequel respectivement au moins un barreau laser (3) est disposé par exemple seulement entre une partie des puits de chaleur (2) formant l'agencement de puits de chaleur (6a), et/ou dans lequel on prévoit par exemple au moins deux canaux (10) passant à travers les puits de chaleur (2) et les couches d'isolation (7) pour l'amenée et l'évacuation de l'agent réfrigérant.

7. Dispositif laser à diodes selon l'une quelconque des revendications précédentes, **caractérisé en ce que**, sur les côtés de surface, formant un côté supérieur et/ou inférieur, de l'agencement de puits de chaleur (6, 6a, 6b) on applique au moins un élément de compensation (16) ou au moins une couche de compensation (7.1, 12.1, 17).

8. Dispositif laser à diodes selon la revendication 7, **caractérisé en ce que** l'au moins un élément de compensation (16) ou l'au moins une couche de compensation (7.1, 17) se compose du matériau de l'au moins une couche d'isolation (7) et/ou d'un matériau qui présente le même, ou sensiblement le même coefficient de dilatation thermique que l'au moins une couche d'isolation (7).

9. Dispositif laser à diodes selon la revendication 7, **caractérisé en ce que** l'au moins une couche de compensation (12.1) se compose du matériau des supports intermédiaires (12) et/ou d'un matériau qui présente le même, ou sensiblement le même coefficient de dilatation thermique que les supports intermédiaires (12).

10. Dispositif laser à diodes selon les revendications 7-9, **caractérisé en ce que** l'au moins un élément de compensation (16) ou l'au moins une couche de compensation (7.1, 12.1, 17) présente le même volume, ou sensiblement le même volume que l'au moins une couche d'isolation (7) ou bien présente un support intermédiaire (12), par exemple identique du point de vue de la taille et de l'épaisseur, ou sensiblement identique, à l'au moins une couche d'isolation (7) ou au support intermédiaire (12).

11. Dispositif laser à diodes selon l'une au moins des revendications 7-10, **caractérisé en ce que** l'au moins un élément de compensation (16) ou l'au moins une couche de compensation (7.1, 12.1, 17) est en liaison avec le puits de chaleur (2) de manière similaire à celle de l'au moins une couche d'isolation (7) en jonction avec le puits de chaleur (2) ou du support intermédiaire (12) en jonction avec le puits de chaleur (2).

12. Dispositif laser à diodes selon l'une des revendications précédentes, **caractérisé en ce que** la profondeur (x) de l'écartement (8) formé entre les au moins deux puits de chaleur (2) comporte au moins 8 mm.

13. Dispositif laser à diodes selon l'une des revendications 7-12, **caractérisé en ce que** l'élément de compensation (16) est réalisé en plusieurs couches, à savoir qu'il se compose de la couche de compensation (17) et d'au moins une métallisation (18) sur un côté de surface, tournant le dos à l'agencement de puits de chaleur (6, 6a, 6b), de la couche de compensation (17), et **en ce que** cette métallisation (18) est au moins en liaison via une métallisation de trous (20) avec le puits de chaleur (2) adjacent.

14. Dispositif laser à diodes selon la revendication 7, **caractérisé en ce que** la couche de compensation (17) est dotée d'une métallisation (19) également sur son côté de surface en liaison avec l'agencement de puits de chaleur (6, 6a, 6b).

15. Dispositif laser à diodes selon l'une des revendications précédentes, **caractérisé en ce qu'**une fente de compensation (15) est formée dans l'agencement de puits de chaleur (6, 6b) entre au moins deux puits de chaleur (2), dans laquelle fente on ne prévoit pas de barreau laser (3) ou un agencement de barreaux laser formé par au moins un barreau laser et des supports intermédiaires (12), et **en ce que**, sur le côté avant (1, 2), il y a une alternance d'écartements (8) avec des barreaux laser (3) ou des agencements de barreaux laser et des fentes de compensation (15).

16. Dispositif laser à diodes selon l'une des revendications précédentes, **caractérisé en ce que** le nombre d'écartements (8) avec des barreaux laser (3) ou des agencements de barreaux laser se situe dans la plage comprise entre 4 et 15.

17. Dispositif laser à diodes selon l'une des revendications 3-16, **caractérisé en ce que**, via un métal d'apport de brasage reliant le support intermédiaire (12) respectif au puits de chaleur (2) adjacent, une compensation de tolérance dans la plage comprise entre 2 et 50 µm est réalisée.

18. Procédé pour la fabrication d'un dispositif laser à diodes avec des barreaux laser (3) qui présentent respectivement au moins un émetteur et sont dotés des deux côtés respectivement d'un support intermédiaire métallique (12), et avec un agencement de puits de chaleur (6, 6a, 6b) pour le refroidissement de l'au moins un barreau laser (3),
dans lequel, en reliant plus de deux puits de chaleur (12) via des couches d'isolation (7), lesquelles sont formées par des couches de céramique, par exemple des couches de céramique en oxyde d'aluminium et/ou nitrure d'aluminium, on produit par collage DCB un agencement de puits de chaleur monolithique (6, 6a, 6b) dans lequel on prévoit, entre deux puits de chaleur (2), respectivement au moins une couche d'isolation (7), et des refroidisseurs actifs étant utilisés ce faisant en tant que puits de chaleur (2), lesquels sont respectivement produits à partir d'une pluralité de couches métalliques reliées en nappe les unes aux autres et dont des couches métalliques intérieures (4) sont structurées pour la formation d'une structure de refroidisseur présentant une pluralité de canaux de refroidissement (11), et
dans lequel on utilise ensuite, entre les puits de chaleur (2) successifs dans l'agencement de puits de chaleur (6), respectivement au moins un barreau laser (3) avec des supports intermédiaires (12) prévus sur celui-ci entre deux puits de chaleur (2), et les supports intermédiaires (12) étant alors reliés avec respectivement un puits de chaleur (2) au niveau de leur zone de montage.

19. Procédé selon la revendication 18, **caractérisé en ce que** l'agencement de puits de chaleur (6, 6a, 6b) est fabriqué avec une pluralité de zones de montage pour la réception respectivement d'au moins un barreau laser (3) doté des supports intermédiaires (12).
